# EUROPEAN PATENT APPLICATION

(11) **EP 3 422 328 A1**
(43) Date of publication of application: **02.01.2019**
(21) Application number: 16906590.1
(22) Date of filing: 28.06.2016
(51) Int. Cl.: G09F 9/30

(54) **FLEXIBLE DEVICE**

(71) Applicant: Shenzhen Royole Technologies Co., Ltd., Shenzhen, Guangdong 518052 (CN)
(72) Inventor: WANG, Chaogang, Shenzhen Guangdong 518052 (CN)
(74) Representative: Maiwald Patent- und Rechtsanwaltsgesellschaft mbH
(86) International application number: PCT/CN2016/087426
(87) International publication number: WO 2018/000187

(57) **Abstract**

Disclosed is a flexible device, comprising an accommodating element and a flexible element capable of folding and extending with respect to the accommodating element, wherein the flexible element comprises a flexible base material, the flexible base material comprises a first surface, and a second surface supporting the flexible base material when the flexible element is extended, and the first surface and the second surface are oppositely arranged; and the flexible element further comprises a support layer fixed on the second surface of the flexible base material, when the flexible element is extended, the support layer generating a force toward the accommodating element so as to reduce or eliminate the warping of the flexible element. The flexible device can effectively prevent the flexible element from warping and ensure normal use of the flexible base material.

## Description

### FIELD

The present disclosure relates to a field of flexible devices, and more particularly to a flexible keyboard.

### BACKGROUND

The keyboard has been widely used as a general peripheral device for computers. The existing keyboard is usually made of a hard plastic material, and can only be placed in a position providing a fixed dimension and thus is not convenient to be carried with. Currently, a flexible keyboard capable of rolling up is provided in the related art, and it can spread out when it is used, otherwise it may be rolled up for storage.

A flexible touchpad is usually used as a flexible element in the flexible keyboard, and the user can touch letters or characters on the flexible touchpad for input. However, after the flexible touchpad has been curved for a long time, warpage may be formed on the conventional flexible touchpad when it is spread out for use, thus affecting normal input of the user.

### SUMMARY

Accordingly, embodiments of the present disclosure provide a flexible device which may reduce warpage.

In embodiments of the present disclosure, a flexible device is provided. The flexible device includes: a housing element; and a flexible element capable of rolling up in the housing element or spreading out from the housing element, in which the flexible element includes: a flexible substrate including a first surface, and a second surface supporting the flexible substrate when the flexible element is spread out, in which the first surface and the second surface are arranged oppositely to each other, and a support layer attached to the second surface of the flexible substrate, in which a force toward the housing element is generated in the support layer when the flexible element is spread out, and reduces or prevents warping of the flexible element.

In an embodiment of the present disclosure, the force toward the housing element is generated in the support layer due to shrinkage of the support layer when the flexible element is spread out.

In an embodiment of the present disclosure, thermal shrinkage of the support layer is greater than that of the flexible substrate.

In an embodiment of the present disclosure, the support layer is attached to the second surface of the flexible substrate by heat treatment.

In an embodiment of the present disclosure, the support layer is made of transparent materials.

In an embodiment of the present disclosure, the support layer includes silica gel.

In an embodiment of the present disclosure, the flexible substrate includes a base, a protection layer, and a functional layer between the base and the protection layer, and the supporting layer is attached to the base.

In an embodiment of the present disclosure, the base, the protection layer and the functional layer are made of transparent materials.

In an embodiment of the present disclosure, the functional layer includes an electrode layer, the first surface of the flexible substrate is a touch surface.

In an embodiment of the present disclosure, the flexible element further includes a cover layer disposed on the first surface of the flexible substrate.

In an embodiment of the present disclosure, the cover layer has a hardness less than that of the flexible substrate.

In an embodiment of the present disclosure, the cover layer has a hardness less than that of the protection layer.

In an embodiment of the present disclosure, the cover layer has a thickness less than that of the support layer.

In an embodiment of the present disclosure, a shrinkage stress generated in the cover layer is less than a shrinkage stress generated in the support layer.

In an embodiment of the present disclosure, the cover layer and the support layer are made of the same material.

In an embodiment of the present disclosure, the cover layer includes silica gel.

In an embodiment of the present disclosure, a plurality of protrusions is formed on a surface of the cover layer, and is operated to simulate keys of a keyboard.

In an embodiment of the present disclosure, the housing element comprises a barrel and a reel disposed in the barrel, and the first surface of the flexible substrate bends and faces to the reel when the flexible substrate is wound around the reel.

In an embodiment of the present disclosure, the first surface is compressed and the second surface is stretched when the flexible element is rolled up.

A force toward the housing element is generated in the support layer and is applied on the second surface for supporting the flexible substrate, such that a warping stress of the flexible element may be reduced or offset and warpage of the flexible element may be reduced or eliminated.

### BRIEF DESCRIPTION OF THE DRAWINGS

Drawings which are involved in the description of embodiments will be introduced below in brief for illustrating technical solutions in embodiments of the present disclosure, it will be appreciated that drawings described below are merely some implementations of the present disclosure, and other modifications can also be obtained by those who skilled in the art, without creative work.
Fig. 1 is a schematic diagram of a flexible device according to an embodiment of the present disclosure.
Fig. 2 is a schematic diagram of a flexible element of the flexible device of Fig. 1.
Fig. 3 is a schematic diagram of a flexible substrate of the flexible element of Fig. 2.
Fig. 4 is a schematic diagram of a flexible device according to another embodiment of the present disclosure.
Fig. 5 is a schematic diagram of a flexible device according to a further embodiment of the present disclosure.
Fig. 6 is a schematic diagram of a flexible device according to a further embodiment of the present disclosure.
Fig. 7 is a diagram showing a force analysis of the flexible element of Fig. 2.
Fig. 8 is a diagram showing a force analysis of the flexible element of Fig. 5.

### DETAILED DESCRIPTION

In order to make purposes, technical solutions and advantages of embodiments of the present disclosure more clear, reference will be made in detail to embodiments of the present disclosure with accompanying drawings.

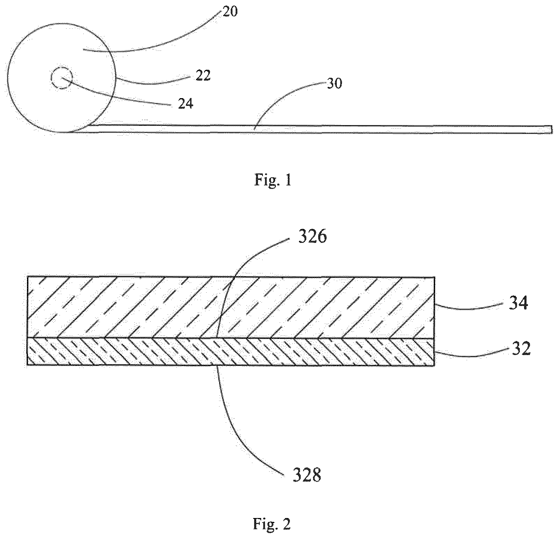

With reference to Fig. 1, a flexible device 10 is provided according to an embodiment of the present disclosure. The flexible device 10 includes a housing element 20 and a flexible element 30. In this embodiment, the housing element 20 includes a barrel 22 and a reel 24 disposed in the barrel 22 and operated to be wound with the flexible element 30. An opening is defined in a side of the barrel 22, and the flexible element 30 may be rolled up into the barrel 22 or spread out from the barrel 22. The barrel 22 is made of hard materials to protect the flexible element 30 contained in the barrel 22. A controller and a power source are also contained in the barrel 22. The power source may provide power to each electronic element in the barrel 22. The controller receives an input signal of the flexible element 30 and to process the input signal, or transmits a signal to the flexible element 30. A communication module may also be integrated in the barrel 22 for connecting the flexible device 10 with an external electronic device (such as a mobile phone, a computer, a tablet and a display) and establishing communication between the flexible device 10 and the external electronic device. The communication module is operated to transmit a signal between the controller and the electronic device, such that the electronic device or flexible element 30 may respond to the signal. Further, a speaker may also be integrated in the barrel 22 and operated to play sound of the signal or other sounds.

With reference to Fig. 2, the flexible element 30 includes a flexible substrate 32. In this embodiment, the flexible substrate 32 is a flexible touchpad. It should be understood that the flexible substrate 32 may also be a substrate having another functions, such as a flexible display.

In an embodiment of the present disclosure, a cover layer 34 may be disposed on a touch surface of the flexible touchpad, which provides a surface for inputting by a user. In this embodiment, the touch surface is an upper surface of the flexible touchpad. The cover layer 34 and the flexible touchpad are able to bend, so as to be rolled up in the housing element 20. Alternatively, the bending radius of the cover layer 34 and the flexible touchpad may be less than 5 mm. The hardness of the cover 34 is less than that of the flexible touchpad. As a result, the softer layer, i.e., the cover layer 34, is touched when the user touches the flexible element 30 and a comfortable feel is thus achieved so as to improve input efficiency. In an embodiment, the cover layer 34 is made of silica gel to provide better bending performance while ensuring the feel. Alternatively, rubber, thermoplastic elastomer (TPE) and other materials can also be used to prepare the cover layer 34, and the effect of silica gel can be substantially achieved. Further, the cover layer 34 is made of transparent materials to enhance the overall appearance and to avoid obstructing the flexible touchpad.

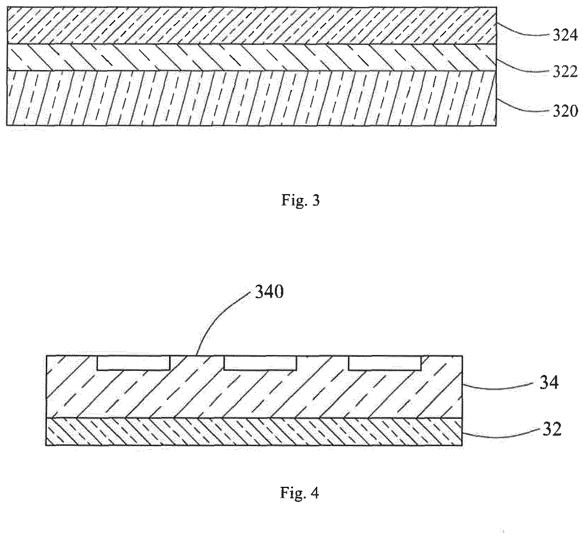

With reference to Fig. 3, the flexible substrate includes a base 320, an electrode layer 322, and a protection layer 324. The base 320, the electrode layer 322, and the protection layer 324 are made of transparent materials. At least one of the base 320, the electrode layer 322, and the protection layer 324 has a higher hardness than that of the cover layer 34. In an embodiment, hardness of the protection layer 324 is more than that of the cover layer 34. The base 320 is configured to support the electrode layer 322 and thus can be used as a support structure for manufacturing the electrode layer 322. The electrode layer 322 is operated to sense a touch action of a user on the touch surface and to generate a touch signal. The electrode layer 322 may be a single electrode layer, or may be an electrode layer having two layers apart by an insulating layer, according to actual requirements. The electrode layer 322 can be made of a transparent conductive material such as silver nanowire and indium tin oxide (ITO). The protection layer 324 is operated to protect the electrode layer 322. The protection layer 324 is made of a material such as polyethylene terephthalate (PET) or polyvinyl chloride (PVC), and has hardness high enough to protect the electrode layer 322. In an embodiment, an upper surface of the protection layer 324 is the touch surface of the flexible touchpad. Further, marks such as letters, symbols and numbers may be defined on the protection layer 324 so as to simulate construction of a keyboard. The marks may be defined on the touch surface by printing or etching, or may be defined on a lower surface of the protection layer 324. Alternatively, letters, symbols, numbers and the like may also be defined on an upper surface or a lower surface of the cover layer 34. Moreover, as shown in Fig. 4, a plurality of protrusions 340 may also be formed on the upper surface of the cover layer 34 for simulating protruding keys in a mechanical keyboard, such that a user feels better when hitting the keys on the cover layer 34.

In an embodiment of the present disclosure, the flexible substrate 32 is a flexible display, and it includes a base 320, a display layer and a protection layer 324. The base 320 and the protection layer 324 can be made of the same material as the base 320 and the protection layer 324 of the flexible touchpad. The display layer may include materials such as an organic light emitting diode (OLED) and E-ink (electronic ink). The display layer and the electrode layer 322 described herein may be regarded as a functional layer of the flexible substrate 32.

Movements of the flexible element 30 are allowed within the housing element 20, such that the flexible device 10 may be adjustable in a first state and a second state. Specifically, when the flexible device 10 is in the first state, the flexible element 30 is rolled up in the housing element 20, such that the flexible device 10 may be carried easily. When the flexible device 10 is in the second state, the flexible element 30 is spread out from the housing element 20, such that a user may touch the touch surface of the flexible element 30 for input. It should be understood that a touch input may be a clicking or a tapping action on the touch surface using a finger or may be a gesture on the touch surface using a finger, such as sliding upwards, sliding downwards, and drawing various symbols, letters, numbers, figures or the like. A first surface 326 of the flexible substrate 32 is a functional surface for providing a desired function (when the flexible substrate 32 is a flexible touchpad, the functional surface is for the touch input by the user; when the flexible substrate 32 is a flexible display, the functional surface is for viewing images by the user). A second surface 328 of the flexible substrate 32 is a support surface, and is used to be placed on a support, such as a table, to support the flexible substrate 32 when the flexible device 10 is in the second state. In addition, the first surface 326 of the flexible substrate 32 is bent and faced to the reel 24 when the flexible element 30 is wound around the reel 24. In this embodiment, the upper surface of the flexible touchpad is the first surface 326, and the lower surface is the second surface 328. In the rolling process of the flexible touchpad, the first surface 326 is shrunken, and the second surface 328 is extended under stress.

The flexible touchpad is curled in the barrel 22 for most of the time and subjected to a continuous stress, such that warpage may be happened to the flexible touchpad when it is spread out. In an embodiment of the present disclosure, after a long period of being curled, an end of the flexible touchpad, which is away from the barrel 22, is more likely to be warped due to a warping stress when the flexible touchpad is spread out, thus affecting experience of user. In order to enable the flexible touchpad to automatically return flat state, embodiments of the present disclosure provide another configuration of the flexible element 30.

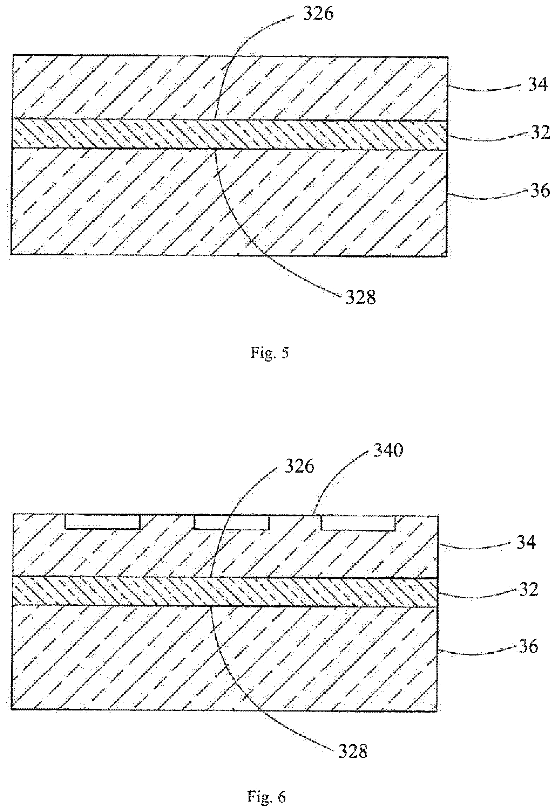

Figs. 5 and 6 show a flexible element 30 of the present disclosed. In addition to the flexible touchpad and cover layer 34, the flexible element 30 further includes a support layer 36. The support layer 36 is located on the lower surface of the flexible touchpad. The support layer 36 may be located on the lower surface of the flexible touchpad by a hot press molding process or an injection molding process. In an embodiment of the present disclosure, the hot press molding process includes coating a surface of the flexible touchpad or the support layer 36 with a liquid adhesive and pressing one of the flexible touchpad and the support layer 36 to another to adhere the flexible touchpad and the support layer 36 with the adhesive. The injection molding process includes placing a flexible touchpad into a mold and then injecting a liquid material of the support layer at a high temperature so as to form a support layer 36 by combining a support layer with the flexible touchpad. In other words, the process of forming the support layer 36 on the flexible touchpad requires heat treatment. After the heat treatment, the temperature is reduced to a room temperature, and a shrinkage stress may be generated in the support layer 36 due to thermal shrinkage. Therefore, the shrinkage stress generated in the support layer 36 may be used to reduce or offset the warping stress of the flexible touchpad.

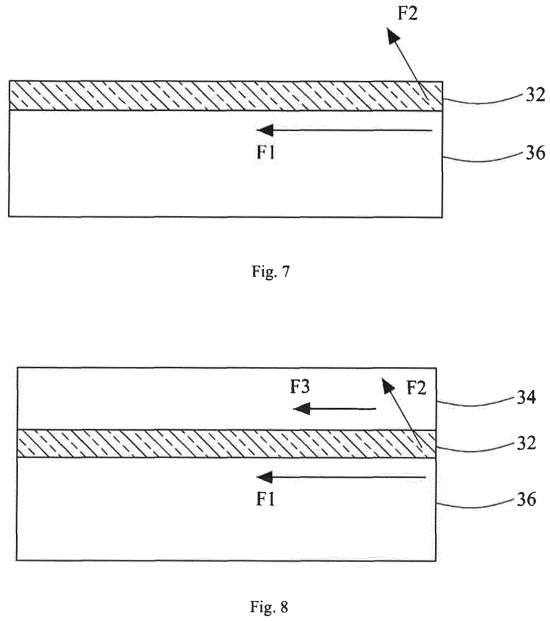

With reference to Fig. 7, thermal shrinkage of the support layer 36 is greater than that of the flexible touchpad. The term "thermal shrinkage" as used in the present disclosure refers to a degree of shrinkage of material having a certain length from a high temperature to a low temperature. Since the thermal shrinkage of the support layer 36 is greater than that of the flexible touchpad, a shrinkage stress generated by the support layer 36 is greater than a shrinkage stress of the flexible touchpad after temperature is reduced from a high temperature to a room temperature. The ends of the support layer 36 and the flexible touchpad are fixed to the housing element 20 and thus cannot be moved, and the other ends away from the housing element 20 are in a free state. A force F1 inward (i.e. toward the barrel) is generated on a lower surface of the free end of the flexible touchpad and such a force F1 may reduce or offset the warping stress F2 of the flexible touchpad, thus preventing the warpage of the flexible touchpad. It is noted that, in this embodiment, the end, away from the barrel, of the flexible touchpad is taken as an example, but in fact, an inward force may be applied to all the lower surface of the flexible touchpad by the support layer 36.

In an embodiment of the present disclosure, the support layer 36 is made of a material having a high thermal shrinkage, such as silica gel, polyvinylidene fluoride (PVDF) and polytetrafluoroethylene (PTFE). In an embodiment of the present disclosure, the support layer 36 is made of silica gel. The support layer 36 may also be transparent so as to avoid affecting appearance of the flexible element 30.

With reference to Fig. 8, a cover layer 34 made of silica gel is arranged on the upper surface of the flexible touchpad, and thus the cover layer 34 has a same thermal shrinkage compared to the support layer 36. On this basis, similar to the principle of the support layer 36, a force F3 inward (i.e., toward the barrel 20) may be generated to apply on the upper surface of the flexible touchpad by the cover layer 34. Such that the free end of the flexible touchpad may have a trend to be pulled inwards due to the force F3 and thus the warpage of the flexible touchpad may happen more easily. In order to counter shrinkage stress generated by the cover layer 34, a greater shrinkage stress is needed in the support layer 36. Therefore, a thickness of the support layer 36 is greater than that of the cover layer 34, so as to simultaneously cancel or reduce the shrinkage stress of the cover layer 34 and the warping stress of the flexible touchpad. Moreover, since the support layer 36 is thicker, a gravity generated by itself can cancel a part of the warping stress, so as to improve an effect of the support layer 36 for canceling or reducing the warping stress. By providing the support layer 36, the flexible element 30 can be in a flat state after being curled for a long time, thus improving the experience of the use.

It can be understood that the support layer 36 may include other materials or other structures to achieve the effect of preventing or reducing the warpage. For example, the support layer 36 may be made of an elastic material, and it is attached to the lower surface of the flexible substrate 32 when the elastic material is in a stretched condition. On this basis, a resilience force may be generated because the elastic material has a shrinkage tendency, and such a resilience force may also reduce or prevent the warpage without the heat treatment.

## Claims

1. A flexible device, comprising:
a housing element; and
a flexible element capable of rolling up in the housing element or spreading out from the housing element,
wherein the flexible element comprises:
a flexible substrate comprising a first surface, and a second surface supporting the flexible substrate when the flexible element is spread out, in which the first surface and the second surface are arranged oppositely to each other, and
a support layer attached to the second surface of the flexible substrate, in which a force toward the housing element is generated in the support layer when the flexible element is spread out, and reduces or prevents warping of the flexible element.

2. The flexible device according to claim 1, wherein the force toward the housing element is generated in the support layer due to shrinkage of the support layer when the flexible element is spread out.

3. The flexible device according to claim 2, wherein thermal shrinkage of the support layer is greater than that of the flexible substrate.

4. The flexible device according to claim 3, wherein the support layer is attached to the second surface of the flexible substrate by heat treatment.

5. The flexible device according to claim 1, wherein the support layer is made of transparent materials.

6. The flexible device according to claim 1, wherein the support layer comprises silica gel.

7. The flexible device according to any one of claims 1 to 6, wherein the flexible substrate comprises a base, a protection layer, and a functional layer between the base and the protection layer, and the supporting layer is attached to the base.

8. The flexible device according to claim 7, wherein the base, the protection layer and the functional layer are made of transparent materials.

9. The flexible device according to claim 8, wherein the functional layer comprises an electrode layer, the first surface of the flexible substrate is a touch surface.

10. The flexible device according to claim 7, wherein the flexible element further comprises a cover layer disposed on the first surface of the flexible substrate.

11. The flexible device according to claim 10, wherein the cover layer has a hardness less than that of the flexible substrate.

12. The flexible device according to claim 10, wherein the cover layer has a hardness less than that of the protection layer.

13. The flexible device according to claim 10, wherein the cover layer has a thickness less than that of the support layer.

14. The flexible device according to claim 10, wherein a shrinkage stress generated in the cover layer is less than a shrinkage stress generated in the support layer.

15. The flexible device according to claim 10, wherein the cover layer and the support layer are made of the same material.

16. The flexible device according to claim 10, wherein the cover layer comprises silica gel.

17. The flexible device according to claim 10, wherein a plurality of protrusions is formed on a surface of the cover layer, and is operated to simulate keys of a keyboard.

18. The flexible device according to any one of claims 1 to 6, wherein the housing element comprises a barrel and a reel disposed in the barrel, and the first surface of the flexible substrate bends and faces to the reel when the flexible substrate is wound around the reel.

19. The flexible device according to any one of claims 1 to 6, wherein the first surface is compressed and the second surface is stretched when the flexible element is rolled up.
